# EUROPEAN PATENT APPLICATION

(11) **EP 4 776 770 A1**
(43) Date of publication of application: **15.07.2026**
(21) Application number: 25215761.5
(22) Date of filing: 14.11.2025
(51) Int. Cl.: H05K 7/20

(54) **CONTROLLING APPARATUS FOR VEHICLE**

(30) Priority: 08.01.2025 KR 20250002584
(71) Applicant: Hyundai Mobis Co., Ltd., Gangnam-gu Seoul (KR)
(72) Inventor: PARK, Sung Hyun, 16891 Yongin-si, Gyeonggi-do (KR); LEE, Hyun Seong, 16891 Yongin-si, Gyeonggi-do (KR); YU, Byung Mo, 16891 Yongin-si, Gyeonggi-do (KR); JEON, Sung Bae, 16891 Yongin-si, Gyeonggi-do (KR); KIM, Su Ji, 16891 Yongin-si, Gyeonggi-do (KR); LEE, Kyeong Jun, 16891 Yongin-si, Gyeonggi-do (KR); KIM, In Gun, 16891 Yongin-si, Gyeonggi-do (KR); YOO, Sung Min, 16891 Yongin-si, Gyeonggi-do (KR)
(74) Representative: Jung, Minkyu

(57) **Abstract**

A controlling apparatus for a vehicle includes: a cover top disposed on an upper end of the controlling apparatus; a moisture blocking cover threadedly engaged to an upper portion of the cover top and blocking moisture from being introduced from an upward direction of the controlling apparatus; a main chassis configured to be coupled to a lower end of the cover top and defining a receiving space for accommodating a PCB of the controlling apparatus; and a fan disposed on either lateral side of the main chassis and generating forced convection in a first direction opposite to the lateral side of the main chassis on which the fan is disposed, wherein the cover top is configured to have a size of a path cross-section formed by a plurality of heat dissipation fins formed in an upward direction in a specific area and the moisture blocking cover is substantially constant in the first direction.

## Description

### CROSS-REFERENCE TO RELATED APPLICATION

This application claims the benefit under 35 USC § 119(a) of Patent Application No. 10-2025-0002584, filed on January 08, 2025 in Korea, the entire disclosure(s) of which is hereby incorporated herein by reference in its entirety.

### TECHNICAL FIELD

The present disclosure relates to a controlling apparatus for a vehicle.

### BACKGROUND

The content described in this section merely provides background information on the present disclosure and does not constitute the prior art.

Controllers with diverse functions and performance requirements are installed in a vehicle. Based on the required performance, the controllers adopt chipsets with varying levels of power consumption. As the power consumption increases, the heat generation of the controller also increases and thus a heat dissipation component and a fan are used to maintain the temperature conditions of the chipset. In particular, in a high-performance controller, a fan that generates forced convection is essentially applied.

The fan applied to the controller is installed either on the outside or inside of the controller to perform a heat dissipation function by generating forced convection at a heat generating source. In order to maximize the effect of forced convection from the fan applied to the controller, it is essential to secure a flow path with an inlet and outlet. However, if an opening such as a hole is formed in the controller to secure the flow path for the fan, there is a problem that moisture may enter from the outside of the controller.

In particular, when the fan is applied to an upper end of the controller, there is a vulnerability to moisture ingress from moisture falling from an upper direction of the controller.

### SUMMARY

In view of the above, an objective of the present disclosure is to block moisture from entering a controlling apparatus, thereby preventing the moisture from reaching a PCB inside the controlling apparatus.

Further, an objective of the present disclosure is to increase the flow velocity of forced convection of a fan using a path cross-section formed between a moisture blocking cover disposed on an upper end of a controlling apparatus and heat dissipation fins, thereby enhancing heat dissipation performance.

The objectives to be achieved by the present disclosure are not limited to the above-mentioned objectives, and other objectives which are not mentioned will be clearly understood by those skilled in the art from the following description.

### ADVANTAGEOUS EFFECTS

According to an embodiment, a controlling apparatus for a vehicle can block moisture from entering the controlling apparatus, thereby preventing the moisture from reaching a PCB inside the controlling apparatus.

According to an embodiment, a controlling apparatus for a vehicle can increase the flow velocity of forced convection of a fan using a path cross-section formed between a moisture blocking cover disposed on an upper end of the controlling apparatus and heat dissipation fins, thereby enhancing heat dissipation performance.

### BRIEF DESCRIPTION OF THE DRAWINGS

Fig. 1 is a diagram illustrating the configuration of a controlling apparatus for a vehicle according to an embodiment of the present disclosure.
Fig. 2 is an exploded perspective view illustrating the configuration of the controlling apparatus for the vehicle according to an embodiment of the present disclosure.
Fig. 3 is a sectional view taken along line A-A of Fig. 1.
Fig. 4 is a sectional view taken along line B-B of Fig. 1.
Fig. 5 is a sectional view taken along line C-C of Fig. 1.
Fig. 6 is a sectional view illustrating a second moisture discharge path of the controlling apparatus for the vehicle according to an embodiment of the present disclosure.

Throughout the drawings and the detailed description, unless otherwise described or provided, the same, or like, drawing reference numerals may be understood to refer to the same, or like, elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment (e.g., as to what an example or embodiment may include or implement) means that at least one example or embodiment exists where such a feature is included or implemented, while all examples are not limited thereto. The use of the terms "example" or "embodiment" herein have a same meaning (e.g., the phrasing "in one example" has a same meaning as "in one embodiment", and "one or more examples" has a same meaning as "in one or more embodiments").

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

The terminology used herein is for describing various examples only and is not to be used to limit the disclosure. The articles "a," "an," and "the" are intended to include the plural forms as well, unless the context clearly indicates otherwise. As nonlimiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

Throughout the specification, when a component or element is described as being "on", "connected to," "coupled to," or "joined to" another component, element, or layer it may be directly (e.g., in contact with the other component, element, or layer) "on", "connected to," "coupled to," or "joined to" the other component, element, or layer or there may reasonably be one or more other components, elements, layers intervening therebetween. When a component, element, or layer is described as being "directly on", "directly connected to," "directly coupled to," or "directly joined" to another component, element, or layer there can be no other components, elements, or layers intervening therebetween. Likewise, expressions, for example, "between" and "immediately between" and "adjacent to" and "immediately adjacent to" may also be construed as described in the foregoing.

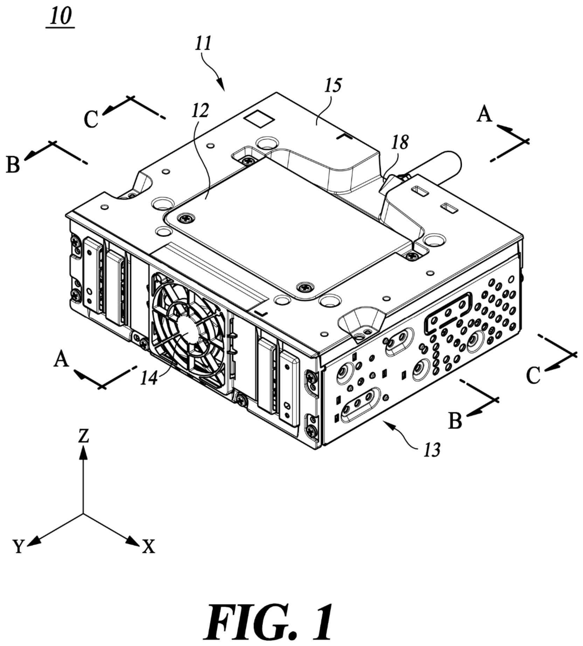

Unless otherwise defined, all terms, including technical and scientific terms, used herein have the same meaning as commonly understood by one of ordinary skill in the art to which this disclosure pertains and specifically in the context on an understanding of the disclosure of the present application. Terms, such as those defined in commonly used dictionaries, are to be interpreted as having a meaning that is consistent with their meaning in the context of the relevant art and specifically in the context of the disclosure of the present application, and are not to be interpreted in an idealized or overly formal sense unless expressly so defined herein. Fig. 1 is a diagram illustrating the configuration of a controlling apparatus for a vehicle according to an embodiment of the present disclosure.

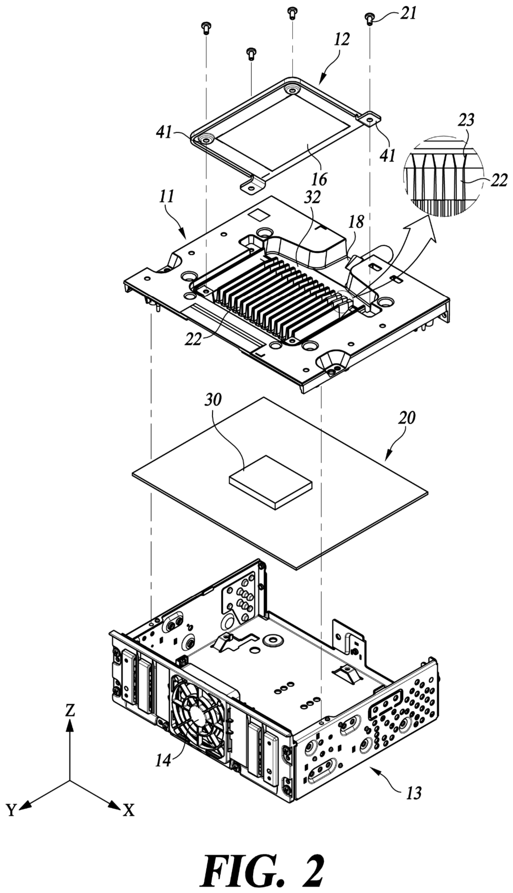

Fig. 2 is an exploded perspective view illustrating the configuration of the controlling apparatus for the vehicle according to an embodiment of the present disclosure.

Referring to Figs. 1 and 2, the controlling apparatus 10 for the vehicle according to an embodiment of the present disclosure includes some or all of a cover top 11, a moisture blocking cover 12, a main chassis 13, a PCB (Printed Circuit Board) 20, and a fan 14.

The cover top 11 is disposed on an uppermost part of the controlling apparatus 10 for the vehicle.

The cover top 11 is coupled to an upper end of the main chassis 13, which will be described later.

The cover top 11 may be made of an aluminum die-casting material. However, the material of the cover top 11 is not limited thereto. It is preferable that the cover top 11 is made of a material with high heat dissipation performance to dissipate heat from the controlling apparatus 10.

The cover top 11 includes heat dissipation fins 22. The heat dissipation fins 22 are formed upward in an area of a drain groove 18. The heat dissipation fins 22 are formed in a direction (the y-axis direction in Fig. 1) parallel to the forced convection direction of the fan 14, and are arranged side by side in the x-axis direction. Thus, the controlling apparatus 10 for the vehicle according to the present disclosure can dissipate heat generated from the inside of the controlling apparatus 10 to the outside, using the fan 14 and the heat dissipation fins 22.

The moisture blocking cover 12 is coupled to an upper portion of the cover top 11 using a screw 21.

The moisture blocking cover 12 and the cover top 11 are fixedly coupled to each other, thereby blocking moisture falling from the upper direction from entering the controlling apparatus 10.

The moisture blocking cover 12 may primarily block moisture that falls and flows from the upper direction of the controlling apparatus 10. The primarily blocked moisture may be discharged to a front of the controlling apparatus 10 (in the y-axis direction of Fig. 1), or be guided to the drain groove 18 and discharged to a rear of the controlling apparatus 10 (the (-) y-axis direction f Fig. 1).

A thermal interface material 16 may be disposed on a rear surface of the moisture blocking cover 12.

The thermal interface material 16 may be, for example, any one of thermal grease, thermal tape, a thermal pad, and phase change material.

The moisture blocking cover 12 includes a plurality of fixing parts 17 to be fastened to an upper end of a cover groove using the screw 21. The plurality of fixing parts 17 may be embossed or formed in the shape of a bracket.

The moisture blocking cover 12 may be masked in an edge area on the rear surface thereof where the thermal interface material 16 is not attached. For example, the edge area on the rear surface of the moisture blocking cover 12 may be black-masked.

Various elements are mounted on the PCB 20. The PCB 20 applied to the vehicle controlling apparatus 10 controls functions such as engine control, transmission control, ABS (Anti-lock Braking System), airbag, body control, infotainment systems, and autonomous driving. In particular, advanced vehicle functions require high-performance CPUs and GPUs.

A heat generating source 30 mounted on the PCB 20 according to an embodiment of the present disclosure may be a CPU (Central Processing Unit). For example, the CPU may be disposed to contact with or be adjacent to a lower end of the drain groove 18 for effective heat dissipation.

The main chassis 13 is disposed on a lower end of the cover top 11. The main chassis 13 and the cover top 11 define a case of the controlling apparatus 10.

The main chassis 13 is formed to protect the PCB 20 housed in the controlling apparatus 10 from external impact.

The fan 14 may be disposed on a lateral side of the main chassis 13.

It is preferable that the fan 14 according to an embodiment of the present disclosure is disposed on the lateral side of the main chassis 13. This is because, if the fan 14 is disposed on an upper side of the controlling apparatus 10, moisture falling and entering from the upper direction of the controlling apparatus 10 may reach the inside of the controlling apparatus 10 via the fan 14.

A material of the main chassis 13 may be, for example, SECC (Steel Electrolytic Cold Commercial) and a PC-ABS alloy. For example, a surface of the main chassis on which the fan 14 is disposed may be made of a PC-ABS alloy.

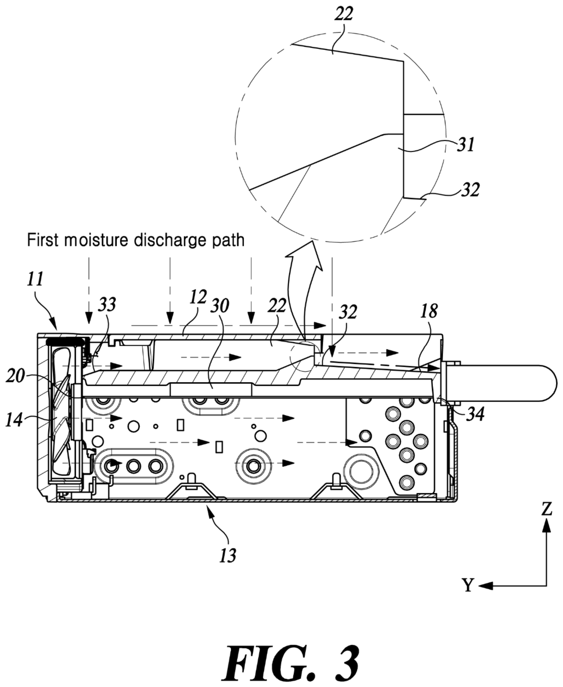

Fig. 3 is a sectional view taken along line A-A of Fig. 1.

Referring to Figs. 1 to 3, the fan 14 according to an embodiment of the present disclosure may generate forced convection in the upper and lower portions of the drain groove 18 to dissipate heat from the heat generating source 30.

The fan 14 may generate forced convection in a first direction (the (-)y-axis direction in Fig. 3) from any one side of the main chassis 13.

The forced convection generated from the fan 14 moves to the rear of the controlling apparatus 10 via the upper and lower portions of the drain groove 18. The forced convection passing through the upper portion of the drain groove 18 moves to the rear via the heat dissipation fins 22. Thus, heat generated from the heat generating source 30 mounted on the PCB 20 is conducted to an area in contact with the lower surface of the drain groove 18, and is conducted to the moisture blocking cover 12 by the heat dissipation fins 22 formed in an area on the drain groove 18. Here, the fan 14 may generate forced convection in the first direction with respect to the heat conducted via the heat dissipation fins 22, thereby enabling effective heat dissipation.

One side and the other side of the drain groove 18 are formed to be open so that the forced convection generated from the fan 14 moves from a second direction side, which is the front side of the controlling apparatus 10, to a first direction side, which is opposite to the second direction, via the heat dissipation fins 22. Specifically, one side of the drain groove 18 adjacent to the fan 14 may be formed with an opening hole corresponding to the size of the fan 14.

The cover top 11 according to an embodiment of the present disclosure includes the drain groove 18.

The drain groove 18 according to an embodiment of the present disclosure is formed in a downwardly bent shape based on a top surface 15 of the cover top 11.

The drain groove 18 has a moisture discharge path that guides and discharges moisture falling from the upper portion of the controlling apparatus 10 in a front-rear direction of the controlling apparatus 10.

The drain groove 18 includes some or all of a moisture-inflow prevention step 31, a first inclined surface 32, a second inclined surface 33, and a bent part 34.

The moisture-inflow prevention step 31 forms a level difference by a predetermined height so that moisture flowing down from the moisture blocking cover 12 is not introduced into the heat dissipation fins 22.

The first inclined surface 32 has a downward slope so that moisture is guided and flows down in the first direction (the (-)y-axis direction in Fig. 3) based on the moisture-inflow prevention step 31.

The second inclined surface 33 has a downward slope so that moisture flows outward from the other end in the second direction (the y-axis direction in Fig. 3) based on the moisture-inflow prevention step 31.

Here, the downward slope of each of the first inclined surface 32 and the second inclined surface 33 may be a slope at which moisture does not accumulate on a plane and does not generate surface tension. In other words, each of the first inclined surface 32 and the second inclined surface 33 may be a tapered surface based on a predetermined slope to prevent moisture from accumulating.

The bent part 34 is formed by bending downward at the other end in the first direction of the first inclined surface 32. The bent part 34 may protect the PCB 20 from moisture flowing from the rear.

The moisture flowing from the upper direction primarily reaches the moisture blocking cover 12 or the top surface 15 of the cover top 11 of the controlling apparatus 10 for the vehicle. Alternatively, the moisture may fall directly onto the first inclined surface 32 of the drain groove 18 and then be introduced.

The controlling apparatus 10 for the vehicle according to an embodiment of the present disclosure includes a first moisture discharge path through which moisture falling onto the moisture blocking cover 12 moves to the rear (the (-)y-axis direction in Fig. 3) and falls onto the second inclined surface 33 of the drain groove 18. The first moisture discharge path has a path in which the moisture falling onto the second inclined surface 33 is discharged to the rear by the second inclined surface 33.

For example, the moisture falling onto the second inclined surface 33 is not introduced to the front by the forced convection of the fan 14. However, even without the forced convection of the fan 14, the moisture falling onto the second inclined surface 33 is not introduced to the front (the y-axis direction in Fig. 3) by the moisture-inflow prevention step 31.

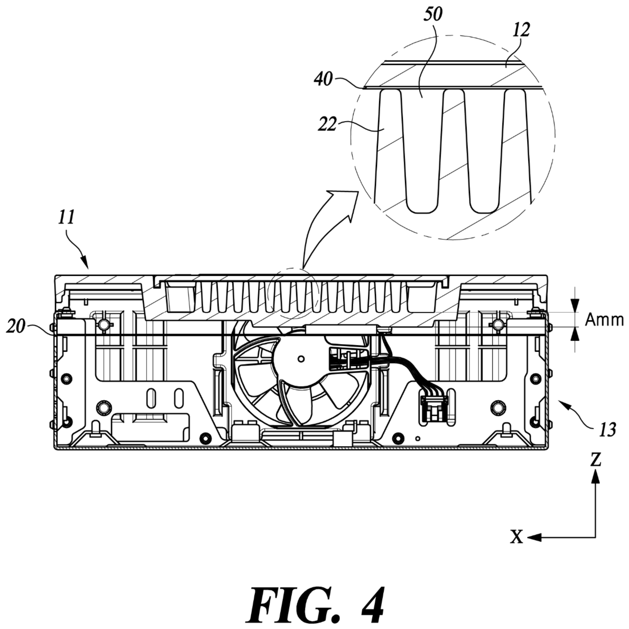

Fig. 4 is a sectional view taken along line B-B of Fig. 1.

Referring to Figs. 1 to 4, when the moisture blocking cover 12 is coupled to the cover top 11, the thermal interface material 16 is disposed to be in contact with the heat dissipation fins 22. The thermal interface material 16 is disposed to be in contact with the heat dissipation fins 22 so that heat emitted from the heat generating source 30 may be dissipated to the upper side of the moisture blocking cover 12.

A first path cross-section 50 is formed between the heat dissipation fins 22 contacting the thermal interface material 16. The formed first path cross-section 50 may increase the flow velocity of the forced convection generated by the fan 14. Therefore, the first path cross-section 50 formed between the moisture blocking cover 12 and the heat dissipation fins 22 can increase the heat dissipation performance compared to a case where the moisture blocking cover 12 is not coupled to the cover top 11.

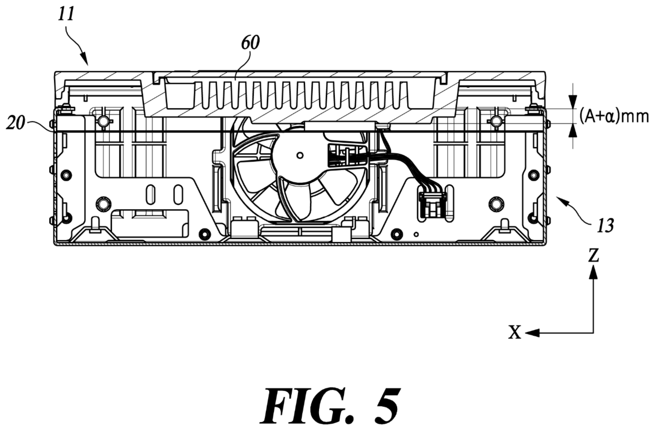

Fig. 5 is a sectional view taken along line C-C of Fig. 1.

Referring to Figs. 1 to 5, the heat dissipation fins 22 according to the present disclosure may be formed to extend to the moisture-inflow prevention step 31 in the first direction. When the heat dissipation fins 22 are formed to extend to the moisture-inflow prevention step 31, the path cross-section between the heat dissipation fins 22 may be formed to be constant.

When the heat dissipation fins 22 according to an embodiment of the present disclosure are formed to extend in the first direction, a second path cross-section 60 may be formed in a section where the thermal interface material 16 and the heat dissipation fins 22 are spaced apart from each other, starting from the first path cross-section 50 formed between the heat dissipation fins 22 contacting the thermal interface material 16. Here, the second path cross-section 60 means a total sectional area that is the sum of a sectional area between the heat dissipation fins 22 and a sectional area between the heat dissipation fins 22 and the thermal interface material 16. In other words, the second path cross-section 60 means path cross-sections formed continuously in the first direction from the section where the thermal interface material 16 and the heat dissipation fins 22 do not contact each other.

The sectional area formed between the heat dissipation fins 22 according to the present disclosure may vary in the first direction depending on a tapered surface 23 of each heat dissipation fin 22. The sum of the sectional area between the heat dissipation fins 22, which vary along the first direction, and the sectional area formed between the heat dissipation fins 22 and the thermal interface material 16 that are spaced apart from each other, forms the second path cross-section 60, which may be formed to be always equal to the sectional area of the first path cross-section 50.

When the forced convection generated from the fan 14 passes between the plurality of heat dissipation fins 22, it may be discharged to the second path cross-section 60 via the first path cross-section 50. In this case, if the area of the first path cross-section 50 is different from that of the second path cross-section 60, it may cause a reduction in flow rate generated from the fan 14. Thus, when the controlling apparatus for the vehicle according to the present disclosure generates the forced convection generated from the fan 14 in the first direction, the areas of the first path cross-section 50 and the second path cross-section 60 may be formed to be the same so that there is no loss of flow rate of the forced convection passing between the heat dissipation fins 22.

The heat dissipation fins 22 corresponding to the second path cross-section 60 of the present disclosure forms the tapered surfaces 23 so that a distance between the heat dissipation fins 22 becomes narrower in the first direction, when viewed from the top. A distance between the heat dissipation fins on the second path cross-section 60 is formed to be spaced apart by a distance sufficient to maintain the surface tension of moisture. In other words, even if moisture is introduced between the heat dissipation fins 22 on the second path cross-section 60 beyond the moisture-inflow prevention step 31, moisture inflow in the second direction may be prevented due to the surface tension phenomenon.

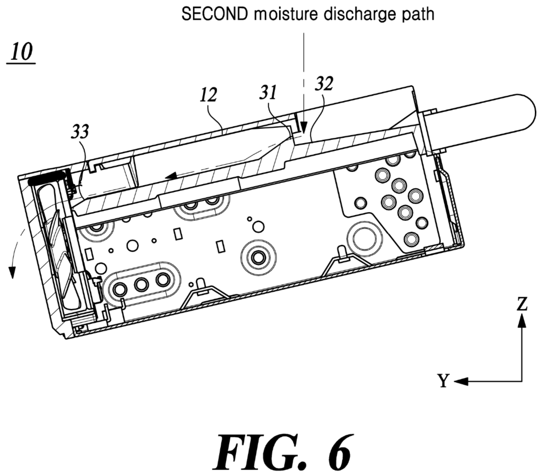

Fig. 6 is a sectional view illustrating a second moisture discharge path of the controlling apparatus for the vehicle according to an embodiment of the present disclosure.

Referring to Figs. 1 to 6, the controlling apparatus 10 for the vehicle according to an embodiment of the present disclosure has the moisture discharge path to discharge the introduced moisture.

The moisture discharge path according to an embodiment guides moisture falling through the moisture blocking cover 12 in the front-rear direction of the controlling apparatus 10.

The moisture discharge path according to an embodiment includes the first moisture discharge path described with reference to Fig. 3 and the second moisture discharge path.

The first moisture discharge path refers to a path in which moisture falling from the upper direction of the controlling apparatus 10 or moisture accumulated on the top surface 15 of the cover top 11 flows along the moisture blocking cover 12, falls to the rear of the controlling apparatus 10, and is discharged to the rear along the second inclined surface 33.

In contrast, the second moisture discharge path refers to a path in which moisture flows along the moisture blocking cover 12, falls to the rear of the controlling apparatus 10, and is discharged to the front of the controlling apparatus 10 along the first inclined surface 32.

The second moisture discharge path according to an embodiment of the present disclosure represents a state in which the controlling apparatus 10 is coupled while tilted forward inside the vehicle or when the vehicle enters a downward slope. Thus, moisture falling along the moisture blocking cover 12 may not be discharged through the second inclined surface 33, but may flow toward the first inclined surface 32 and be discharged to the front of the controlling apparatus 10.

The moisture discharged to the front of the controlling apparatus 10 based on the second moisture discharge path passes through the first inclined surface 32 and is discharged to the outside through the fan 14.

Various embodiments of the present disclosure do not list all available combinations but are for describing a representative aspect of the present disclosure, and descriptions of various embodiments may be applied independently or may be applied through a combination of two or more.

A number of embodiments have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

While this disclosure includes specific examples, it will be apparent after an understanding of the disclosure of this application that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims and their equivalents, and all variations within the scope of the claims and their equivalents are to be construed as being included in the disclosure.

## Claims

1. A controlling apparatus for a vehicle comprising:
a cover top disposed on an upper end of the controlling apparatus;
a moisture blocking cover threadedly engaged to an upper portion of the cover top and blocking moisture from being introduced from an upward direction of the controlling apparatus;
a main chassis configured to be coupled to a lower end of the cover top and defining a receiving space for accommodating a PCB of the controlling apparatus; and
a fan disposed on either lateral side of the main chassis and generating forced convection in a first direction opposite to the lateral side of the main chassis on which the fan is disposed,
wherein the cover top is configured to have a size of a path cross-section formed by a plurality of heat dissipation fins formed in an upward direction in a specific area and the moisture blocking cover is substantially constant in the first direction.

2. The controlling apparatus of claim 1, wherein the cover top is configured to form a drain groove having a moisture discharge path that guides moisture falling toward the PCB through the moisture blocking cover in a front-rear direction of the controlling apparatus.

3. The controlling apparatus of claim 2, wherein the drain groove comprises:
a moisture-inflow prevention step configured to form a level difference by a predetermined height to prevent moisture falling from the moisture blocking cover from entering in a second direction which is opposite to the first direction on the controlling apparatus;
a first inclined surface having a downward inclination so that moisture flows down in the first direction with respect to the moisture-inflow prevention step;
a second inclined surface having a downward inclination so that moisture flows down in the second direction with respect to the moisture-inflow prevention step; and
a bent part formed by bending in a downward direction from one end of the first inclined surface in the first direction.

4. The controlling apparatus of any one of claims 1 to 3, wherein the moisture blocking cover is disposed so that a thermal interface material is adhered to a rear surface and a portion of the thermal interface material and the plurality of heat dissipation fins contact each other.

5. The controlling apparatus of any one of claims 1 to 4, wherein the moisture blocking cover contacts the plurality of heat dissipation fins to form a plurality of first path cross-sections, and forms a second path cross-section having an area that is equal to a sum of areas of the plurality of first path cross-sections.

6. The controlling apparatus of claim 4 or 5, wherein the moisture blocking cover is masked in an edge region of the rear surface where the thermal interface material is not attached.

7. The controlling apparatus of any one of claims 2 to 6, wherein the drain groove is open at one side and the other side so that forced convection generated from the fan moves in the first direction via the plurality of heat dissipation fins.

8. The controlling apparatus of any one of claims 2 to 7, wherein the moisture discharge path comprises:
a first moisture discharge path through which moisture is discharged toward a rear of the controlling apparatus, which is the first direction of the drain groove; and
a second moisture discharge path through which moisture is discharged toward a front of the controlling apparatus, which is a second direction of the drain groove.

9. The controlling apparatus of claim 8, wherein the second moisture discharge path is a path through which moisture falling from the moisture blocking cover is guided and discharged toward the fan, when the controlling apparatus is disposed to be tilted forward.

10. The controlling apparatus of any one of claims 1 to 9, wherein the moisture blocking cover comprises a plurality of fixing parts configured to be threadedly engaged to the cover top.
